(19) Europäisches Patentamt
European Patent Office
Office européen des brevets

(11) Numéro de publication: **0 098 225**
**A1**

(12) # DEMANDE DE BREVET EUROPEEN

(21) Numéro de dépôt: **83401349.2**

(22) Date de dépôt: **30.06.83**

(51) Int. Cl.³: **H 01 L 31/02**
H 01 L 31/18

(30) Priorité: **30.06.82 FR 8211485**

(43) Date de publication de la demande:
**11.01.84 Bulletin 84/2**

(84) Etats contractants désignés:
**AT BE CH DE FR GB IT LI LU NL SE**

(71) Demandeur: **SAINT-GOBAIN RECHERCHE**
**39 quai Lucien Lefranc**
**F-93300 Aubervilliers(FR)**

(72) Inventeur: **Vedel, Jacques**
**28 rue Lemaitre**
**F-92000 Nanterre(FR)**

(72) Inventeur: **Bougnot, Josianne**
**La Tramontane Chemin des Pins**
**F-34170 Castelnau-le-Lez(FR)**

(72) Inventeur: **Savelli, Michel Villa 20 les Aiguelongues**
**Av. Val de Montferrand**
**F-34000 Montpellier(FR)**

(72) Inventeur: **Thiebaut, Bruno**
**20 rue Pierre Marcel**
**F-94250 Gentilly(FR)**

(74) Mandataire: **Le Vaguerese, Sylvain Jacques et al,**
**SAINT-GOBAIN RECHERCHE 39, quai Lucien Lefranc**
**F-93304 Aubervilliers Cedex(FR)**

(54) **Méthode de fabrication de photopiles sulfure de cadmium-sulfure de cuivre.**

(57) La présente invention a pour objet un perfectionnement au procédé de fabrication des photopiles sulfure de cadmium-sulfure cuivreux.

Dans ce procédé on forme sur la couche de sulfure de cadmium, une couche de sulfure cuivreux par échange d'ions, et pour favoriser la stoechiométrie du sulfure cuivreux formé, on impose un potentiel cathodique à la couche de CdS immergée dans une solution contenant des ions cuivreux.

Le procédé selon l'invention permet d'obtenir dans des conditions avantageuses des photopiles présentant de bonnes caractéristiques.

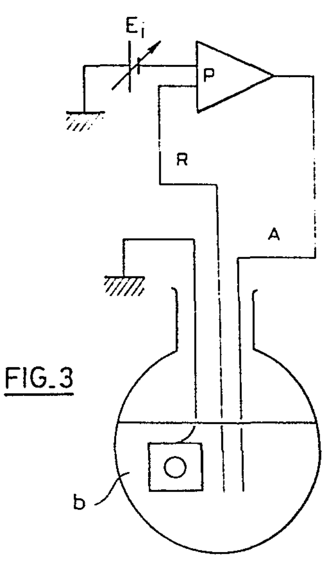


FIG_3

EP 0 098 225 A1

# METHODE DE FABRICATION DE PHOTOPILES

# SULFURE DE CADMIUM-SULFURE DE CUIVRE

La présente invention a pour objet un perfectionnement au procédé de fabrication des photopiles sulfure de cadmium-sulfure cuivreux.

On sait que les photopiles CdS-$Cu_2S$ sont constituées d'un empilement de matériaux dont le but est de transformer l'énergie lumineuse en énergie électrique, de collecter le courant ainsi produit et de protéger l'ensemble des agents extérieurs.

La transformation de l'énergie se fait à l'interface entre du sulfure de cadmium (semi-conducteur de type n) et du sulfure cuivreux (semi-conducteur de type p).

La collecte de courant se fait de deux façons.

Si le semi-conducteur qui reçoit la lumière le premier est le sulfure cuivreux, on a une cellule de type dit "frontwall". Le sulfure de cadmium est déposé en général par évaporation sous vide sur un support conducteur et opaque (matériau plastique revêtu d'une couche métallique, tel qu'un polymide qui résiste à des températures élevées commercialisé sous le nom de KAPTON, ou bien verre argenté). Le sulfure cuivreux est formé à la surface du CdS par échange d'ions avec une solution d'ions cuivreux, sous forme de complexe. Par exemple, en présence d'ions chlorure, la réaction est la suivante :

$$CdS + 2CuCl_2^{-} \longrightarrow Cu_2S + CdCl_4^{2-} \qquad (1)$$

Le courant est collecté par une grille conductrice collée, pressée ou électrodéposée sur la surface du $Cu_2S$. Une couche de protection est ensuite superposée.

Si le premier semi-conducteur à recevoir la lumière est le sulfure de cadmium, on a une cellule de type dit "backwall". Le CdS est déposé en général par pulvérisation sur une couche d'oxyde transparent et conducteur, lui-même déposé sur une plaque de verre. Le sulfure cuivreux est déposé comme précédemment. Ensuite une couche conductrice

(qui peut ici être opaque) est appliquée contre la couche de sulfure cuivreux, afin de pouvoir collecter le courant, et l'ensemble est protégé par superposition d'une couche de protection.

On sait que le sulfure cuivreux $Cu_xS$ présente très fréquemment un rapport stoechiométrique x différent de deux. D'autre part, le rendement des piles est d'autant plus élevé que la valeur de x est proche de deux. Enfin l'expérience a montré que le rapport stoechiométrique obtenu après réaction (1) est rarement égal à deux et est d'autant plus éloigné de cette valeur que la quantité de $Cu_xS$ formé est faible. On est cependant limité dans l'épaisseur de sulfure de cuivre que l'on peut fabriquer : dans le cas des cellules frontwall, une couche épaisse causerait une absorption de la lumière à une distance trop éloignée de la jonction et entraînerait une diminution du rendement par combinaison prématurée des porteurs ; dans le cas des cellules backwall, un temps de séjour trop long de la couche de CdS dans la solution d'échange d'ions (rendu nécessaire pour obtenir une grande quantité de $Cu_2S$) entraînerait une pénétration trop importante du cuivre dans les joints de grains et causerait une diminution de la résistance shunt et, par suite, du rendement. La photopile serait en outre moins stable.

Il apparaît donc nécessaire d'améliorer le rapport stoechiométrique du $Cu_xS$ sans avoir à trop augmenter l'épaisseur de sulfure cuivreux (on admet généralement que la couche de sulfure cuivreux doit avoir une épaisseur moyenne ne dépassant pas 0,8 micromètre environ). Pour cela on peut imaginer d'apporter un supplément de cuivre, dont le rôle est double :

- compenser le défaut de cuivre grâce à la réaction :

$$Cu_xS + (2 - x)\ Cu \longrightarrow Cu_2S \qquad (2)$$

cette réaction est favorisée par un recuit convenable ;

- former, à la surface du sulfure cuivreux une couche d'oxyde cuivreux qui diminue la vitesse de recombinaison en surface des porteurs. Pour cela, un recuit est effectué à l'air.

Une première technique possible consiste en un dépôt de cuivre par évaporation sous vide. Une seconde technique consiste en une réduction partielle du sulfure cuivreux dans un plasma d'hydrogène :

$$Cu_xS + 2H \longrightarrow H_2S + Cu \qquad (3)$$

Toutefois, ces deux techniques présentent certains inconvénients.

Dans les deux cas, il est nécessaire de mettre les photopiles dans une enceinte spéciale, à environnement contrôlé (vide ou hydrogène

sous pression réduite) et de procéder à une opération physique particulière (évaporation du cuivre, génération de plasma). En outre, dans le second cas, la quantité de cuivre déposé ne peut être contrôlée que par un réglage rigoureux des conditions expérimentales.

On a maintenant découvert qu'il était possible d'améliorer la stoechiométrie du sulfure cuivreux en imposant un potentiel cathodique à la photopile, en tirant parti du fait qu'il existe une couche conductrice sous le sulfure de cadmium (l'électrode collectrice de la photopile).

Comme cela a été indiqué ci-dessus, on a constaté que la formation de sulfure cuivreux par réaction d'échange d'ions telle que la réaction (1) conduit constamment à un sulfure $Cu_xS$ pour lequel x est inférieur à 2.

On peut faire diverses hypothèses sur les raisons de cet écart avec la théorie, mais toutes ces hypothèses ont en commun de supposer la présence d'un oxydant susceptible de conduire à la formation d'un sulfure cuivreux partiellement oxydé en produit cuivrique.

On a toutefois constaté que la présence d'un réducteur tel que par exemple l'hydrazine dans la solution d'échange d'ions, ne permet pas d'éviter la formation de sulfure de cuivre non stoechiométrique.

On a maintenant découvert que, de façon surprenante, le fait d'imposer à la couche de CdS un potentiel cathodique, pendant la réaction d'échange d'ions, permet d'obtenir un sulfure de cuivre ayant une stoechiométrie améliorée.

Bien entendu, le potentiel cathodique imposé doit dans ce cas être supérieur au potentiel correspondant au dépôt électrolytique de cuivre, de façon à ne pas contrarier la réaction d'échange d'ions.

On a également découvert qu'il est possible d'améliorer la stoechiométrie du dépôt de sulfure de cuivre en imposant à la photopile un potentiel cathodique après la réaction d'échange d'ions, dans une solution d'électrolyte contenant des ions cuivreux : le potentiel imposé doit alors être suffisant pour permettre un dépôt de cuivre sur le $Cu_xS$.

La photopile sert alors de cathode dans un système de dépôt électrolytique de cuivre. Cette opération est appelée par abréviation "recharge cathodique".

On a découvert que le dépôt cathodique de cuivre peut, de façon avantageuse, être effectué directement dans le bain d'échange

d'ions, après formation du $Cu_xS$, ce qui permet de simplifier notablement le procédé de fabrication.

Pour déposer le cuivre, on peut :

- soit imposer une tension constante entre une anode de cuivre et la photopile ;

- soit imposer un courant constant entre ces mêmes électrodes.

Dans le premier cas, la quantité de cuivre est contrôlée par l'intégration du courant d'électrolyse, dans le second, par une mesure du temps de dépôt.

La présente invention a donc pour objet un procédé de préparation de photopiles à sulfure de cadmium-sulfure de cuivre dans lequel on forme sur la couche de sulfure de cadmium une couche de sulfure de cuivre par échange d'ions, caractérisé par le fait que, pour favoriser la stoechiométrie du sulfure cuivreux formé, on impose à la couche de sulfure de cadmium immergée dans une solution d'ions cuivreux un potentiel cathodique.

Le procédé selon l'invention peut présenter des caractéristiques additionnelles qui apparaissent dans les diverses formes de réalisation envisagées :

Dans le cas où ledit potentiel cathodique est appliqué après la réaction d'échange d'ions, c'est-à-dire après formation de la couche sous-stoechiométrique de $Cu_xS$, et à partir d'une solution contenant des ions cuivreux, on choisit la durée de son application de façon à obtenir un dépôt de cuivre correspondant à une quantité de cuivre de 10 à 100 microgrammes par $cm^2$ environ et en particulier de 25 à 50 microgrammes par $cm^2$. La valeur de ce potentiel doit être supérieure à celle du potentiel de réduction du solvant contenu dans la solution, sinon il risque de se produire des phénomènes perturbant les mécanismes électrochimiques mis en jeu. En particulier, lorsque le solvant utilisé est de l'eau, on impose un potentiel cathodique supérieur au potentiel de réduction des ions $H^+$.

Selon une forme préférée de l'invention, les ions cuivreux proviennent par exemple de complexes halogénés d'halogénure cuivreux de formule $CuX_2^-$, X étant un atome d'halogène choisi parmi le chlore, le brome et l'iode. Les ions halogénure sont présents en excès, leur concentration étant cependant limitée. En effet, si leur concentration augmente trop, le cuivre sera fortement complexé, et l'entité $CuX_2^-$ stabilisée. Avantageusement, on se limitera à une concentration inférieure à 0,5 mole par litre environ.

Pour des raisons analogues, on maintient le pH à des valeurs comprises entre 1,5 et 4,5 environ, et de préférence entre 2 et 4 environ. Eventuellement, on peut introduire dans la solution un tampon qui stabilise d'une part la concentration en ions cuivreux et d'autre part le pH.

Les ions cuivreux doivent être présents dans la solution à une concentration suffisante pour que les proportions stoechimétriques dans la couche soient atteintes, mais cependant pas trop importantes pour éviter une réaction trop rapide qui nuirait à l'homogénéité du dépôt. De préférence, on choisira une concentration, exprimée en poids de chlorure cuivreux, entre 0,4 et 0,6 % environ.

En théorie, le cuivre commence à se déposer lorsque le potentiel de la photopile traitée est nul par rapport à une anode de cuivre de référence. Toutefois, en raison de l'existence des surtensions cathodiques, il est préférable, selon l'invention, de se placer à un potentiel compris entre - 0,35 et - 0,7 volt environ, et en particulier entre - 0,45 et - 0,55 volt environ.

On opère à une température qui peut être comprise entre 0 et 99°C environ. Cependant on se place avantageusement à une température comprise entre 90 et 99°C, la formation de $Cu_2S$ étant favorisée par une élévation de température.

La solution contenant des ions cuivreux dans laquelle s'effectue le dépôt de cuivre, peut, selon une caractéristique supplémentaire de l'invention, être la solution d'échanges d'ions à partir de laquelle on a procédé au dépôt de la couche de $Cu_xS$. Dans ce cas, il suffit d'imposer le potentiel cathodique convenable ; simplement en imposant à la photopile un certain potentiel cathodique, on peut alors améliorer la stoechiométrie du dépôt de sulfure cuivreux en procédant au dépôt de cuivre. Le procédé selon l'invention est donc particulièrement simple à mettre en oeuvre, notamment en comparaison des techniques sophistiquées de dépôt de cuivre sous vide.

Eventuellement, selon une caractéristique supplémentaire de l'invention, on peut imposer un potentiel de ce type également pendant la réaction d'échange d'ions, afin d'améliorer son efficacité.

Dans le cas où on impose ledit potentiel cathodique pendant la réaction d'échange d'ions, il est souhaitable d'éviter la réduction directe en cuivre afin de ne pas perturber la réaction d'échange. On se place avantageusement à un potentiel compris entre - 0,05 et - 0,25 volt environ.

La solution d'échange d'ions permettant la formation de la couche de sulfure cuivreux contient avantageusement au moins un complexe $CuX_2^-$ du type mentionné précédemment ; elle présente les mêmes caractéristiques de pH, de concentration des espèces en solution, de température, que la solution d'ions cuivreux convenant pour le dépôt de cuivre. Toutefois, on opérera de préférence à une température comprise entre 90 et 99°C. On peut donc sans difficulté opérer le dépôt de cuivre, ou la recharge cathodique de cuivre, directement à partir de la solution où s'est fait l'échange d'ions ; soit en imposant un potentiel cathodique si l'échange d'ions a eu lieu sans assistance électrochimique, soit en modifiant le potentiel cathodique précédemment imposé pour la réaction d'échange d'ions.

D'une façon générale, la réaction d'échange d'ions est effectuée pendant un temps suffisant pour obtenir une couche de sulfure cuivreux d'épaisseur désirée. Généralement on forme une couche d'une épaisseur de 0,5 à 0,8 micromètre environ.

Les exemples suivants et les dessins annexés illustrent l'invention sans toutefois la limiter.

La figure 1 représente une photopile de type frontwall, comprenant une plaque de verre 1, une couche métallique 2, une couche de CdS 3, une couche de sulfure cuivreux 4, une grille métallique 5 et une couche de protection 6.

La figure 2 représente une photopile de type backwall, avec une couche de verre 1, une couche transparente conductrice 2 (telle que $SnO_2$), une couche de sulfure de cadmium 3, et une couche de sulfure cuivreux 4 recouverte d'une couche conductrice 5 et d'une couche de protection 6.

La signification des figures 3 et 4 est donnée ci-après, dans la partie expérimentale.

<u>EXEMPLE 1</u> : Echange d'ions sous potentiel cathodique

Sur une plaquette carrée en verre pyrex de dimensions 20 X 20 mm, recouverte d'une couche fine de $SnO_2$ on dépose une couche de CdS spray. On protège par du ruban adhésif, au centre de la plaquette, une surface circulaire de diamètre 15,2 mm. Le CdS extérieur à cette surface circulaire protégée est éliminé par décapage à l'acide chlorhydrique. On dépose alors sur la plaquette une couche de nickel à l'aide d'un bain de Watts standard. Un fil de contact est collé contre la partie nickelée avec une colle conductrice à l'argent. Le ruban adhésif est enlevé. On met alors en place un autre ruban adhésif qui masque la partie métallisée et qui ne libère qu'une surface circulaire de CdS de diamètre 11,2 mm.

La composition de la solution aqueuse d'échange d'ions est la suivante :

- NaCl : 25 g/l
- tartrate de sodium ($C_4H_4Na_2O_6$, $2H_2O$) : 20 g/l
- chlorhydrate d'hydrazine : 5 g/l
- chlorure cuivreux : voir ci-après

Une électrode de cuivre est placée dans la solution d'échange d'ions. Elle est reliée à un voltmètre à haute impédance d'entrée. L'autre borne (+) du voltmètre est reliée au fil de contact de la photopile.

On a effectué cette réaction d'échange d'ions à la température de 80°C, en imposant à la photopile un potentiel par l'intermédiaire d'un potentiostat, selon le schéma représenté à la figure 3, dans laquelle A représente l'électrode auxiliaire, R l'électrode de référence (cuivre), P le potentiostat imposant le potentiel Ei, et b la plaquette revêtue de CdS immergé. Dans le cas présent, l'électrode auxiliaire est en platine, mais elle peut être en tout autre matériau, du cuivre par exemple, qui ne risque pas de mettre dans la solution des espèces susceptibles de la polluer.

Les conditions de la réaction étaient les suivantes :

| | | | |
|---|---|---|---|
| Concentration en CuCl (g/l) | 3,0 | 4,5 | 6,0 |
| Durée de la réaction (s) | 15 | 22,5 | 30 |
| Potentiel imposé (mV) | - 100 | - 200 | - 300 |

Chaque valeur de chacun des trois paramètres étudiés a été combinée avec toutes les valeurs des autres paramètres, et l'étude statistique des résultats a montré que, pendant la réaction d'échange d'ions sous potentiel imposé, l'écart à la stoechiométrie est acceptable si le potentiel imposé est inférieur, en valeur absolue, à 300 millivolts.

Dans les conditions étudiées, la valeur optimale du potentiel cathodique à imposer doit être recherchée au voisinage de - 0,1 volt environ (par rapport à l'anode de cuivre).

EXEMPLE 2 : Dépôt de cuivre : essais comparatifs

Des essais comparatifs ont été effectués : à partir d'un même lot de CdS spray, on a effectué un dépôt de sulfure de cuivre par échange d'ions, puis on a préparé deux séries de piles, l'une en utilisant la technique de dépôt de cuivre sous vide, l'autre la technique de dépôt électrolytique dans le bain d'échange d'ions. Dans ce dernier cas, les conditions du dépôt étaient les suivantes :

a) Composition de la solution d'échange d'ions :
- chlorure d'ammonium : 20 $gl^{-1}$
- tournure de cuivre : 5 $gl^{-1}$
- chlorure cuivreux : 6 $gl^{-1}$

b) Température : 99°C

c) Durée de l'échange d'ions : 3 à 10 secondes

d) Potentiel de dépôt de cuivre : - 0,45 à - 0,55 volt pendant 10 à 25 s.

e) Quantité de cuivre déposée : 250 à 500 Å, recuit 160°C, 1 h 30 à l'air puis 1 h sous azote.

Les caractéristiques courant-tension des photopiles obtenues ont été tracées (figure 4). La courbe 1 corespond à l'échantillon obtenu avec dépôt de cuivre par évaporation (9c83). La courbe 2 correspond à l'échantillon obtenu après dépôt électrolytique de cuivre (11c83). Les paramètres de courbes sont reproduits dans le tableau ci-dessous.

| n° d'échantillon | V circuit ouvert Vco (Volts) | Intensité court-circuit $I_{CC}$(mA $cm^{-2}$) | rendement énergétique (en %) |
|---|---|---|---|
| 9c83* | 0,400 | 21 | 5 |
| 11c83** | 0,420 | 22 | 6,5 |

* cuivre déposé par évaporation sous vide

** cuivre déposé par réduction cathodique

On voit que les performances obtenues sont les mêmes.

D'autres essais ont été réalisés. La tension de dépôt doit

être supérieure à - 0,7 volt et au plus égale à - 0,35 volt ou bien la densité de courant doit être comprise entre 1 et 10 mA/cm$^2$.

La concentration en chlorure de la solution doit être inférieure à 1 M pour éviter la co-réduction de l'hydrogène.

Le présent exemple illustre en outre le fait que, pour la recharge cathodique en cuivre, la présence de tartrate de sodium et d'hydrazine (souvent utilisés dans les bains d'échange d'ions) n'est pas indispensable. Elle ne nuit pas, toutefois, à l'obtension d'un dépôt électrolytique de cuivre.

EXEMPLE 3 : Effet de l'échange d'ions sous potentiel cathodique

On effectue la réaction d'échange d'ions dans une solution à 0,6 % de chlorure cuivreux, à 99°C. En opérant de façon analogue à celle décrite à l'exemple 1, on impose un potentiel de - 50 mV par rapport au cuivre.

La durée de la réaction d'échange d'ions est de 15 secondes.

La recharge de cuivre se fait par évaporation sous vide et est suivie d'un recuit standard.

Les caractéristiques des photopiles obtenues sont les suivantes :

| n° d'échantillon | Vco (volts) | Icc (mA/cm$^2$) | rendement énergétique |
|---|---|---|---|
| 13c83 | 0,430 | 20 | 5,5 % |

En outre on a constaté que cette technique apporte une nette amélioration de la reproductibilité des essais.

Par comparaison, une photopile réalisée sans assistance électrochimique, avec recharge en cuivre par évaporation sous vide, a donné les résultats suivants :

| n° d'échantillon | Vco (volts) | Icc (mA/cm$^2$) | rendement |
|---|---|---|---|
| 4c83 | 0,410 | 18 | 4 % |

EXEMPLE 4 : Recharge d'ions sans assistance électrochimique

Recharge en cuivre par potentiel cathodique

La recharge cathodique est effectuée à - 0,500 V (par rapport à l'anode de cuivre). Les résultats sont résumés dans le tableau suivant :

| n° d'échantillon | Tr (s) | Vco (volts) | I(mA/cm$^2$) | rendement |
|---|---|---|---|---|
| 8c83 | 3 | 0,350 | 20 | 3,0 % |
| 11c83 | 6 | 0,420 | 22 | 6,5 % |

Tr : temps de recharge cathodique à - 0,500 V (par rapport à l'anode de cuivre) dans la solution d'échange d'ions qui a la composition du bain décrit à l'exemple 2.

Le recuit est un recuit standard.

REVENDICATIONS

1. Procédé de préparation de photopiles à sulfure de cadmium-sulfure de cuivre, dans lequel on forme sur la couche de sulfure de cadmium, une couche de sulfure cuivreux par échange d'ions, caractérisé par le fait que, pour favoriser la stoechiométrie du sulfure cuivreux formé, on impose un potentiel cathodique à la couche de CdS immergée dans une solution contenant des ions cuivreux.

2. Procédé selon la revendication 1, caractérisé par le fait que l'on impose ledit potentiel cathodique après la réaction d'échange d'ions, dans une solution contenant des ions cuivreux, pendant un temps suffisant pour obtenir un dépôt de cuivre qui équivaut à une quantité moyenne du cuivre de 25 à 50 microgrammes par $cm^2$ environ, ledit potentiel cathodique étant supérieur au potentiel de réduction du solvant.

3. Procédé selon la revendication 2, caractérisé en ce que le potentiel cathodique est supérieur au potentiel de réduction des ions $H^+$.

4. Procédé selon la revendication 2 ou la revendication 3, caractérisé par le fait que lesdits ions proviennent des complexes halogénés d'halogénure cuivreux, de formule $CuX_2^-$, X étant un atome d'halogène choisi parmi le chlore, le brome et l'iode.

5. Procédé selon la revendication 4, caractérisé par le fait que les ions halogénure sont présents en excès, leur concentration étant cependant inférieure à 0,5 mole/litre environ.

6. Procédé selon l'une quelconque des revendications 2 à 5, caractérisé par le fait que le pH est compris entre 1,5 et 4,5 environ, et de préférence entre 2 et 4 environ.

7. Procédé selon l'une quelconque des revendications 2 à 6, caractérisé par le fait que la concentration en ions cuivreux, exprimée en poids de chlorure cuivreux, varie de 0,4 à 0,6 % environ.

8. Procédé selon l'une quelconque des revendications 2 à 7, caractérisé par le fait que ledit potentiel cathodique est de - 0,35 à - 0,7 volt environ (par rapport à une anode de cuivre).

9. Procédé selon la revendication 8, caractérisé par le fait que ledit potentiel varie de - 0,45 à - 0,55 volt.

10. Procédé selon l'une quelconque des revendications 2 à 9, caractérisé par le fait que l'on opère à température comprise entre 0 et 99°C.

11. Procédé selon l'une quelconque des revendications précédentes, caractérisé par le fait que l'on impose un potentiel cathodique

pendant la réaction d'échange d'ions, ce potentiel étant inférieur, en valeur absolue, au potentiel de dépôt du cuivre.

12. Procédé selon la revendication 11, caractérisé par le fait que la solution d'échange d'ions est la même que celle utilisée ultérieurement pour le dépôt du cuivre.

13. Procédé selon la revendication 11 ou la revendication 12, caractérisé par le fait que le potentiel cathodique pendant la réaction d'échange d'ions, est de - 0,05 à - 0,25 volt environ (par rapport à une anode de cuivre).

14. Procédé selon l'une quelconque des revendications 11 à 13, caractérisé par le fait que ladite réaction d'échange d'ions est effectuée pendant un temps suffisant pour obtenir une couche de sulfure cuivreux d'épaisseur de 0,5 à 0,8 micromètres environ.

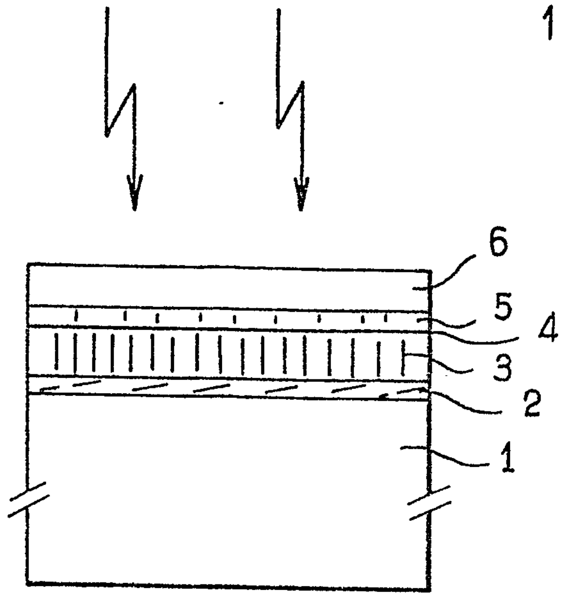


FIG_1

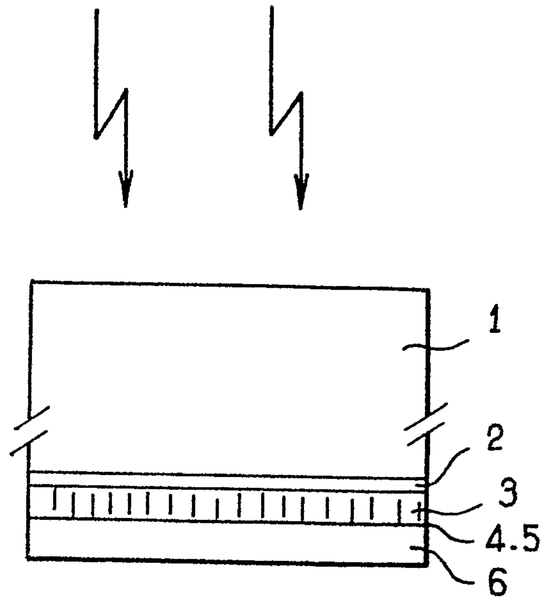


FIG_2

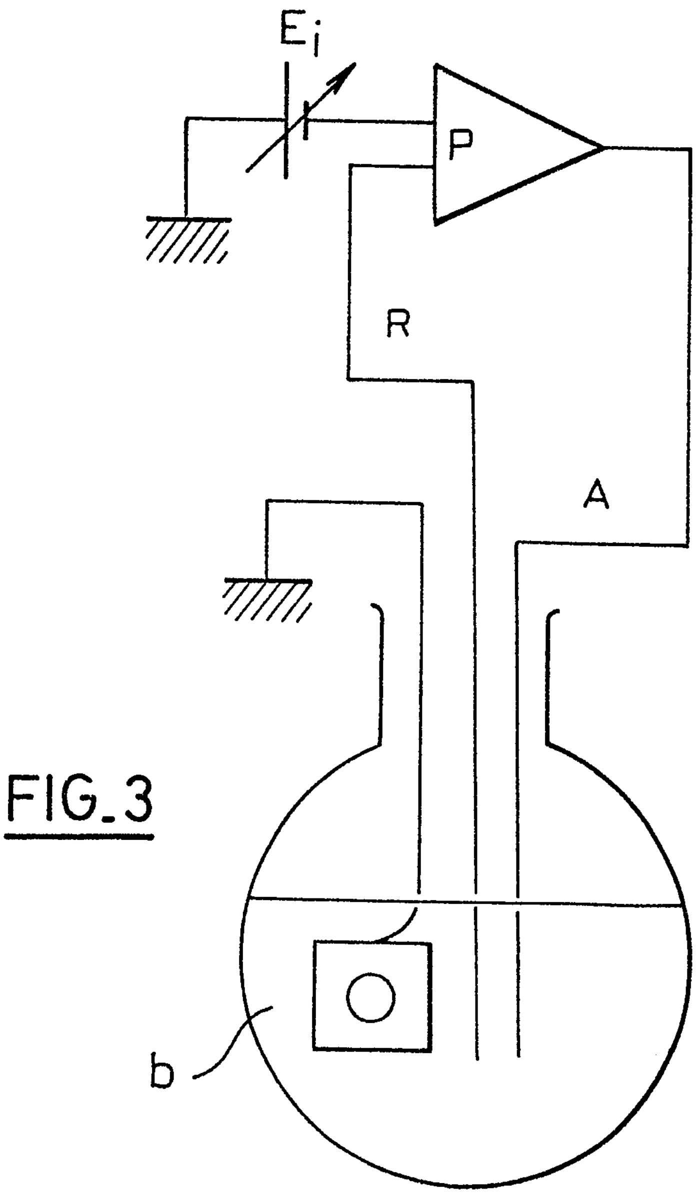


FIG_3

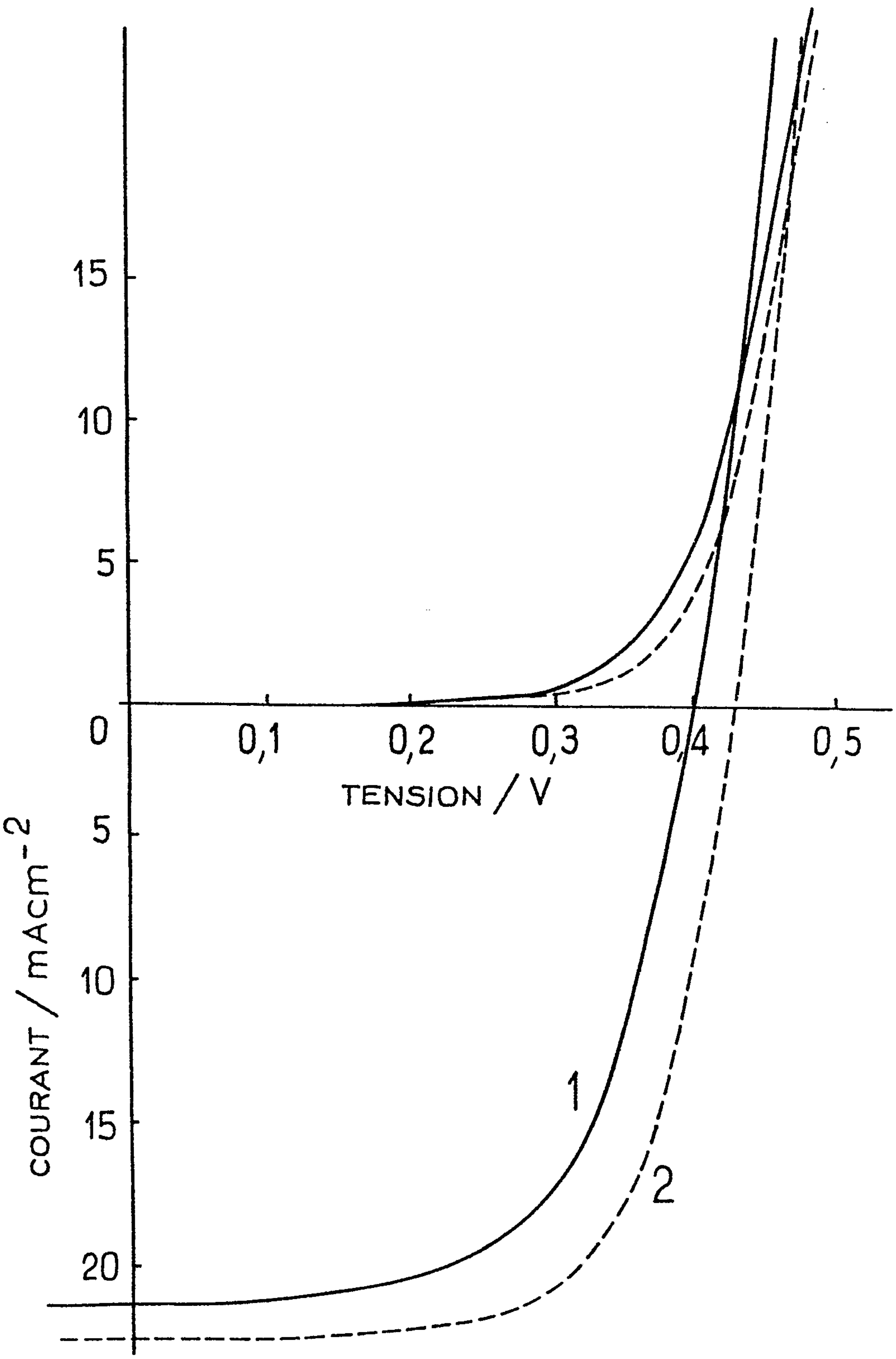


FIG_4

0098225

Office européen des brevets

# RAPPORT DE RECHERCHE EUROPEENNE

Numéro de la demande

EP 83 40 1349

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
| --- | --- | --- | --- |
| A | DE-A-2 621 920 (D.H. BALDWIN CO.) * Pages 24,25; revendication 32 * --- | 1 | H 01 L 31/02<br>H 01 L 31/18 |
| A | JAPANESE JOURNAL OF APPLIED PHYSICS, vol. 19, no. 1, janvier 1980, pages 129-134, Tokyo, JP. H. MATSUMOTO et al.: "Preparation and photovoltaic properties of screen printed CdS/CUxS solar cells" * Page 130; figure 3 * --- | 1 | |
| A | FR-A-2 188 303 (S.A.T.) * En entier * --- | 1 | |
| A | FR-A-2 156 924 (LICENTIA) * En entier * --- | 1,2 | DOMAINES TECHNIQUES RECHERCHES (Int. Cl. 3) |
| A | US-A-4 167 805 (PHOTON POWER) ----- | | H 01 L |

Le présent rapport de recherche a été établi pour toutes les revendications

| Lieu de la recherche | Date d'achèvement de la recherche | Examinateur |
| --- | --- | --- |
| LA HAYE | 11-10-1983 | GORUN M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant